# EUROPEAN PATENT SPECIFICATION

(11) **EP 2 260 312 B1**
(45) Date of publication and mention of the grant of the patent: **09.05.2012**
(21) Application number: 09726219.0
(22) Date of filing: 24.03.2009
(51) Int. Cl.: G01R 31/12, G01R 31/327, H02H 1/00

(54) **ARC FAULT ROOT-CAUSE FINDER SYSTEM AND METHOD**
SYSTEM UND VERFAHREN ZUM AUFFINDEN DER URSACHE VON LICHTBOGENFEHLERN
SYSTÈME ET PROCÉDÉ DE DÉTECTION DE LA CAUSE PREMIÈRE D UN DÉFAUT D ARC

(30) Priority: 25.03.2008 US 39208 P; 23.03.2009 US 408822
(43) Date of publication of application: 15.12.2010
(73) Proprietor: Siemens Industry, Inc., Alpharetta, GA 30005-4437 (US)
(72) Inventor: RESTREPO, Carlos, Atlanta GA 30316 (US)
(74) Representative: Payne, Janice Julia
(86) International application number: PCT/US2009/001842
(87) International publication number: WO 2009/120324

(56) References cited:
- EP-A- 0 945 949
- GB-A- 2 370 127
- US-A- 6 157 527
- US-A1- 2004 100 274
- US-A1- 2005 057 261
- US-B1- 7 221 283

## Description

### TECHNICAL FIELD:

The present invention relates generally to an arc fault system and method used to determine the root-cause of an arc fault condition.

### BACKGROUND ART:

Prior art arc fault testers can only perform the tasks of testing the branch circuit and making sure that an electronic circuit breaker (AFCI/GFCI) is capable of tripping in the case of an arc or ground fault occurs. There are many disadvantages and problems associated with prior art testers. First, the prior art tester must be connected to outlet tested. The electrician/user must connect to the prior art tester to the outlet, then test the breaker, then go back to panel/load center to switch the breaker back to the ON position. A typical prior art tester only makes sure the breakers are property connected and the branch is protected accordingly. Specifically, currently available AFCI devices are only assigned the tasks of monitoring and protecting branch circuits in the home against arc faults and not to tell you were the fault located or where the electrician should start looking for the source of those conditions. Some prior art testers do not recognize the signals generated by the tester as "True" Arc Fault Signals.

Therefore, what is needed is an improved arc fault tester.

US2005/057261 describes a system for remote detection and location of damaged conductors, particularly in avionics and automotive applications.

US6157527 describes a method of communicating with electronic circuit breakers in a power distribution system, using a load centre monitor to monitor, analyse, and control the circuit breakers.

US7221283 relates to a system for identifying a circuit interrupter.

EP0945949 relates to a portable multifunction tester for an AC electrical distribution system

### DISCLOSURE OF THE INVENTION:

This invention eliminates the problems and deficiencies of prior art testing devices and is directed to a novel testing device that provides a visual indication of fault status. The testing device of the present invention is configured for use by an electrician to root-cause the potential location of an arc fault. The present invention can be used by electrician to do the work that would normally require two engineers, two walkie-talkie radios (communication means) and an oscilloscope.

Therefore, in one aspect, the present invention is directed to an arc fault root-cause finder apparatus and method for determining the root-cause of an arc fault condition. In one embodiment, the arc fault root-cause finder apparatus has a sensing base module mounted to a load panel box having at least one circuit breaker that protects a corresponding branch circuit. The sensing base module has sensing electronics that are electrically connected to the at least one circuit breaker and are configured to sense the occurrence of arcing events in the branch circuit. The sensing base module includes wireless communication electronics to (i) effect transmission of electrical signals that provide information about the occurrence or absence of arcing events in the branch circuit, and (ii) to receive command signals. The arc fault root-cause finder apparatus also has a remote user interface module that has wireless communication electronics configured to establish communication with the sensing base module so as to receive signals transmitted by the sensing base module and to transmit control signals to the sensing base module. The remote user interface module has a visual display device to display information received from the sensing base module about the branch circuit.

In a related aspect, the present invention is directed to a method for finding the root-cause of an arc fault comprising providing at least one circuit breaker that protects a corresponding branch circuit having at least one load device electrically connected to the branch circuit, energizing the at least one load device, sensing the occurrence arcing events in the branch circuit, generating electrical signals that represent whether an arcing event has occurred in the branch circuit, processing the generated electrical signals to derive data that represents either the occurrence or absence of an arcing event in the branch circuit, and displaying the data on a display device. The data is also stored in a data storage device. In a further embodiment, the method further includes the steps of generating electrical signals that represent the characteristics of a true arc and ground fault conditions, injecting the electrical signals into the branch circuit, determining if the installed circuit breaker associated with the branch circuit is functioning properly, and generating information signals that indicate if the installed circuit breaker is or is not functioning properly.

### BRIEF DESCRIPTION OF THE DRAWINGS:

Although the scope of the present invention is much broader than any particular embodiment, a detailed description of the preferred embodiment follows together with drawings. These drawings are for illustration purposes only and are not drawn to scale. Like numbers represent like features and components in the drawings. The invention may best be understood by reference to the ensuing detailed description in conjunction with the drawings in which:
FIG. 1 is a block diagram of a testing apparatus in accordance with one embodiment of the present invention;
FIG. 2 is a block diagram of a testing apparatus in accordance with another embodiment of the present invention;
FIG. 3 is a diagram of the sensing base module shown in FIG. 1;
FIG. 4 is a diagram of the remote user interface module shown in FIG. 1;
FIG. 5 is a diagram of the branch protection testing module shown in FIG. 1.

### BEST MODE FOR CARRYING OUT THE INVENTION:

The present invention provides a user, electrician or technician the ability to root-cause a branch circuit in which an arc fault has been found. The present invention provides a user with the ability to accurately determine the source of a potential problem found by an Arc Fault Circuit Interrupter (AFCI). The present invention will help the user locate the source of the problem in less time in comparison to prior art devices.

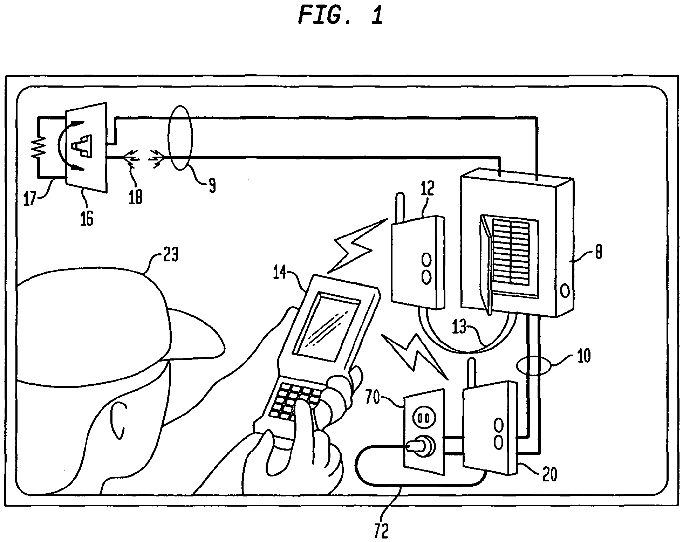

Referring to FIG. 1, there is shown the arc fault root-cause finder apparatus of the present invention which generally comprises sensing base module 12 and remote user interface module 14. Load panel box 8 has a plurality of circuit breakers or AFCI/GFCI devices therein that are electrically connected to corresponding branch circuits. Branch circuit 9 is one of the branch circuits. Branch circuit 10 is another branch circuit. Sensing base module 12 can be mounted directly to load panel box 8 or it can be situated nearby. Wires or cables 13 electrically connect sensing base module 12 to each branch circuit. Specifically, sensing base module 12 is connected to the load power and load neutral connections of the electronic circuit breaker (or AFCI) protecting the branch circuit in question. As will be described in the ensuing description, the connections between sensing base module 12 and the load power and neutral connections of the electronic circuit breakers enable sensing base module 12 to sense the branch circuit as a user 23 (e.g. technician, electrician, operator, etc.) is energizing suspect appliances, outlets or switches, that are connected to each of the branch circuits. Sensing base module 12 has an additional connection to a main phase which provides power to the electronics of sensing base module 12 in case the circuit breaker trips during trouble shooting. The main function of sensing base module 12 is to monitor and record information about each branch circuit as the electrician energizes or stimulates each branch circuit. This information is then relayed to the remote user interface module 14 for immediate feedback to the electrician or user 23. Remote user interface module 14 is preferably a handheld device used by the user or electrician 23 to configure and set up sensing base module 12 to test and troubleshooting a particular branch circuit and receive feedback information during testing of that branch circuit. Remote user interface module 14 allows the user to set up all relevant tests or settings in sensing base module 12. Remote user interface module 14 is also used to record and store any arc fault events or conditions (data) found diagnosing the branch circuit. Remote user interface module 14 is configured to download the data for further analysis if required. Sensing base module 12 and remote user interface module 14 communicate through a standard wireless connection (Wi-Fi, Zigbee, etc.) and exchange commands and data depending on the operational mode of the testing apparatus of the present invention. Remote user interface 14 will be discussed in detail in the ensuing description. For the purposes of illustration the branch circuit 9 having an electrical switch 16 with impedance 17 is shown with a fault 18.

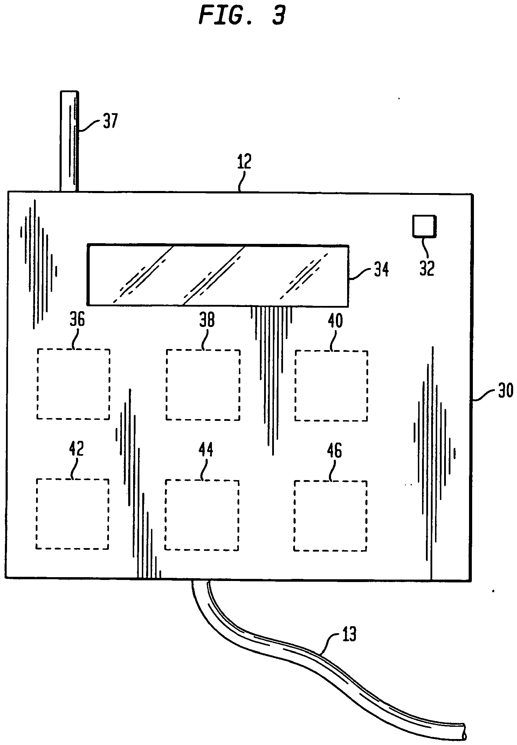

Referring to FIGS. 1 and 3, sensing base module 12 is connected to the root of the branch circuit (load power and neutral connections of the circuit breaker) and senses any electrical events in the line that may be indicative of an arc fault. Wires 13 include wires that are permanently connected to a main phase point in the load panel box 8 in order to power the electronics in sensing base module 12. Referring to FIG. 3, sensing base module 12 comprises enclosure or housing 30 and fastening devices (not shown) that enable enclosure or housing 30 to be attached to load panel box 8. Sensing base module 12 includes activation switch 32 and at least one visual indicator or display device 34 that indicates the operational status and function of sensing base module 12. As described in the foregoing description, wires 13 include wires that are electrically connected to the load power and neutral connections of the branch circuits being tested. Sensing base module 12 comprises wireless communication electronics 36 and antenna 37 for communicating wirelessly to other modules of the arc fault root-cause finder apparatus of the present invention. Sensing base module 12 includes sensing electronics 38 which monitor the line for load current, load voltage and broadband RF content in the branch circuit being tested. Sensing base module 12 also includes processing electronics 40 to process the sensed information provided by the sensing electronics 38 and establish a relative benchmark indicative to likelihood of an arc fault existing in the branch circuit. Sensing base module 12 includes data storage electronics 42 to record events that can be considered arc faults and additional processing electronics 44 to administer all requests received from remote user interface module 14 and corresponding responses to those requests issued by sensing base module 12. Processing electronics 44 also manages all exchanges of commands and information between the sensing base module 12 and remote user interface module 14. Processing electronics 40 processes the electrical signals, electrical events or conditions it senses from the branch circuit and processes these signals or events to determine how likely the signal, event or condition is related to an arc fault. Processing electronics 40 then generates data signals containing information about the electrical signal, event or condition occurring in the branch circuit. These data signals are temporarily stored in memory or data storage device 46.

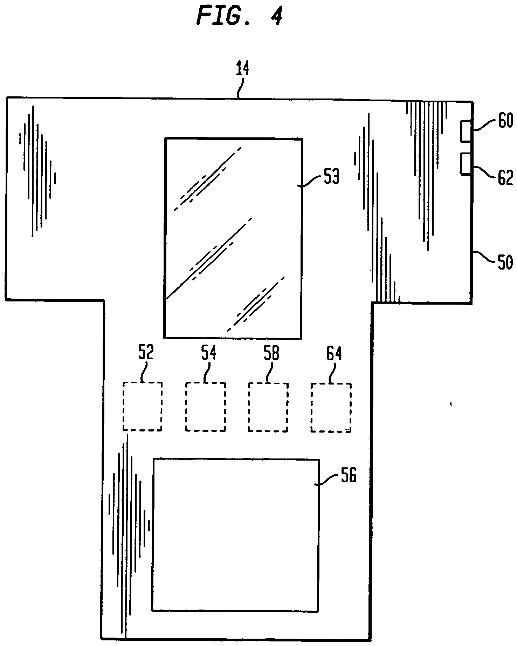

As shown in FIGS. 1 and 4, remote user interface module 14 is configured preferably as a handheld device that is used by the user 23 (e.g. technician, electrician, operator, etc.) to receive feedback during his efforts to find the source of the potential arc fault. The electronics of the remote user interface module 14 is within enclosure or housing 50. Enclosure or housing 50 is configured to be easily carried in the hand of the user 23. Remote user interface module 14 is preferably battery-operated and has wireless communication electronics 52 for wireless communication with sensing base module 12 and any other modules. Remote user interface module 14 includes visual indicator or display device 53 for displaying and providing all feedback information and test results to the user. Visual display device 53 may comprise an LCD screen or other display, lights, etc. that can provide status information related to the tests performed. Visual display device 53 provides the information and data in a clear, concise and simple manner in order to avoid the user having to be involved in the decision as to whether a particular load is the source of the problem. Remote user interface module 14 further includes electronics 54 which is in electronic signal communication with visual display device 53. Electronics 54 effects coordination of all tests and also effects display of the status of completed tests as well as any acknowledgements related to functionality of circuit breakers, wiring of the branch circuit and any other information regarding the operation of the system. Keypad 56 is in electronic signal communication with visual display device 53 and all other electronics described in the foregoing and ensuing description of remote user interface module 14. Remote user interface module 14 includes electronics and circuitry 58 for receiving and buffering electronic signals, storing data signals (e.g. memory) and routing data signals. In a preferred embodiment, remote user interface module 14 includes interface devices 60 and 62 such as PC interfaces, and USB ports, Firewire ports and Flashcard ports, which allow the user to record and store data and then extract the stored data and load it on a personal computer for further analysis. Remote user interface module 14 further includes communication recordation electronics 64 that manages all exchanges of commands and information between sensing base module 12 and remote user interface module 14. Thus, as can be seen by the foregoing description, remote user interface module 14 includes electronics to (i) establish a communication link between with the other modules in tester apparatus 10, (ii) indicate and send command requests to the other modules, and (iii) receive and record data provided by either sensor base module 12 or branch protection testing module 20 during testing, which is described in detail in the ensuing description.

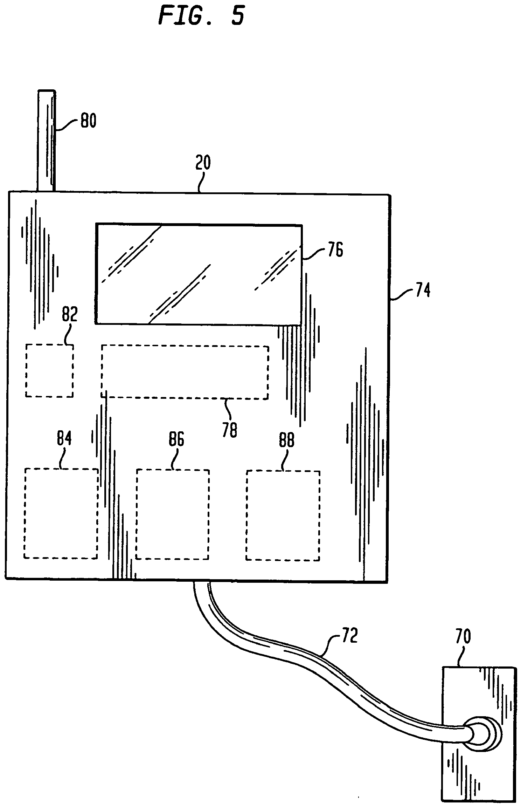

As shown in FIGS. 1 and 5, in another embodiment, arc fault root-cause finder apparatus of the present invention further comprises branch protection testing module 20 that allows testing of a particular branch circuit to determine if that branch circuit is properly protected by an AFCI/GFCI device. Branch protection testing module 20 verifies complete protection of the branch circuit and acknowledges proper or improper installation of the circuit breaker or AFCI/GFCI device. Branch protection testing module 20 is configured to be plugged into wall outlet 70 and includes an AC power cord 72. Branch protection testing module 20 generates signals or conditions that represent the characteristics of true arc and ground fault conditions thereby allowing the user to accurately validate the function of the installed circuit breakers (AFCI/GFCI) and ensure the protection of the branch circuit. The branch protection testing module 20 comprises enclosure or housing 74 and visual indicator or display device 76. Display device 76 can be configured as lights, LCD displays, LEDs, etc. or any other suitable visual indicators that can display or indicate operation and function. Branch protection testing module 20 includes wireless communication electronics 78 and antenna 80 to effect wireless communication with sensing base module 12 and remote user interface module 14. Branch protection testing module 20 also includes electronics 82 for administering all responses to requests issued by remote user interface module 14. Branch protection testing module 20 further includes communication recordation electronics 84 that manages all exchanges of commands and information between the modules. As described in the foregoing description, branch protection testing module 20 includes electrical circuitry and electronics 86 for generating a signal or conditions that represent a true arc fault and injecting such true arc fault signal into the branch circuit line via AC cord 72. Branch protection testing module 20 also includes electrical circuitry and electronics 88 for generating a true ground fault signal in the line, and for verifying the wiring of the branch circuit under test. The electronics of remote user interface module 14 is configured to issue commands that cause branch protection testing apparatus 20 to initiate and start the tests.

### Operation of the Testing Apparatus

The ensuing description pertains to the proper use of the arc fault root-cause finder apparatus of the present invention to find the location of an arc fault and to evaluate the proper protection of the branch circuit by the installed electronic circuit breaker. This installed electronic circuit breaker can be a Branch Feeder, an AFCI device or a GFCI device. First, sensing base module 12 is electrically connected to the circuit breaker devices protecting the branch circuits to be tested so that sensor base module 12 can sense signals on each portion of each branch circuit. The user then ensures the branch circuit wiring is properly connected to the proper circuit breaker. Next, the handheld remote user interface module 14 is operated to establish communication with sensing base module 12. The user then uses the remote user interface module 14 to initiate set up and start the root-cause test. Next, the user walks around the house or building and energizes each load connected to the branch circuit. In order to energize each branch circuit being tested, the user activates the devices that are plugged into electrical outlets that are part of the branch circuit being tested. For example, the user will turn on appliances, lamps, ceiling fans, ceiling lights, TVs, appliances, etc. one at a time. Activation of each load device causes generation of electrical signals or conditions that are processed by sensing base module 12. Sensor base module 12 then transmits feedback information to remote user interface module 14 for immediate feedback. Visual display device 53 of remote user interface module 14 provides the user with information to determine whether a particular load device is the source of the problem. The user repeats these steps for all load devices connected to the branch circuit being tested. In order to conduct testing of AFCI/GFCI, branch protection module 20 is connected to an electrical outlet (e.g. outlet 70) that is part of the branch circuit under test. Branch protection module 20 determines whether the branch circuit is properly wired. The user operates remote interface module 14 to communicate with branch protection module 20. Remote interface module 14 then transmits a command to branch protection testing module 20 to start a branch circuit test (AFCI/GFCI). Branch protection testing module 20 then generates a required signal and injects this signal into the line. If the electronic circuit breaker trips, then branch protection testing module 20 transmits a signal to remote interface module 14 that acknowledges the test was successful. If the test is not successful, then branch protection module 20 transmits a signal to remote interface module 14 to indicate the test was not successful.

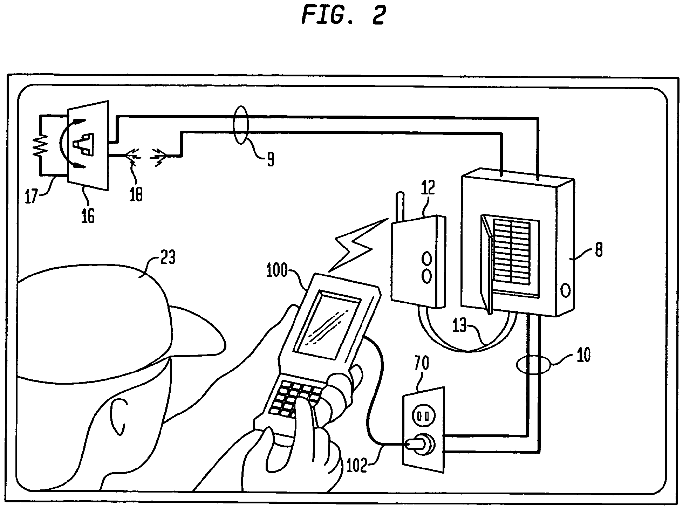

In an alternate embodiment, remote user interface module 14 and one or more branch protection testing modules 20 are combined into preferably a single hand-held unit 100. Such an embodiment is shown in FIG. 2. Remote user interface module 100 comprises all of the electronics, components, hardware and software of both remote user interface module 14 and branch protection testing module 20. Remote user interface module 100 includes AC power cord 102 that is plugged into electrical outlet 70. Electrical outlet 70 is electrically connected to the branch circuit under test.

The present invention provides many advantages over the prior art devices. First, the present invention has the ability to locate the exact location in the branch circuit wherein the branch circuit arc faults occurred unlike the currently available and prior art testing devices. The present invention reduces time in troubleshooting the branch circuit to find the root-cause and also eliminates the need for wires to connect modules 12 and 14. The present invention is also configured to capture data that can be analyzed at a later time with more sophisticated equipment. Remote user interface module 14 is in electrical signal communication with modules that are physically connected to the outlets and circuit breaker thereby providing ample freedom for the technician to operate. The use of multiple branch protection testing modules 20 allow users (e.g. technicians or electricians) to test all branches

while being close to the panel or load center since the branch protection testing modules 20 are linked to the remote user interface module 14 module via wireless communication. Furthermore, the signals generated by branch protection testing module 20 are based on the characteristics of "True" arc fault conditions and are not a derived adaptation.

While the present invention has been particularly described in conjunction with a specific preferred embodiment, it is evident that many alternatives, modifications and variations will be apparent to those skilled in the art in light of the foregoing description.

## Claims

1. An arc fault root-cause finder apparatus, comprising one of a sensing base module (12) and a branch protection module (20); wherein
the sensing base module (12) is mounted to a load panel box (8) having at least one circuit breaker that protects a corresponding branch circuit, the sensing base module comprises sensing electronics (38) that are electrically connected to the at least one circuit breaker and are configured to sense the occurrence of arcing events in the branch circuit (9, 10), the sensing base module including wireless communication electronics (36) to (i) effect transmission of electrical signals that provide information about the occurrence or absence of arcing events in the branch circuit (9, 10), and (ii) to receive command signals; wherein
the branch protection testing module (20) is for use with an electrical power distribution system having at least one circuit breaker that protects a corresponding branch circuit and is in electrical signal communication with the branch circuit and comprising wireless communication electronics (78) and additional electronics and electrical circuitry (86, 88) to (i) generate electrical signals that represent the characteristics of a true arc and ground fault conditions, (ii) inject the electrical signals into the branch circuit, and (iii) determine the integrity of the wiring in the branch circuit, (iv) determine if the installed circuit breaker associated with the branch circuit is functioning properly, and (v) generate information signals that indicate if the installed circuit breaker is or is not functioning properly; and wherein
the apparatus further comprises a remote user interface module (14) comprising wireless communication electronics (52) configured to establish communication with the sensing base module (12) or branch protection testing module (20) so as to receive signals transmitted by the sensing base module (12) or branch protection testing module (20) and to transmit control signals to the sensing base module or branch protection testing module, the remote user interface module further comprising a visual display device (53) to display information received from the sensing base module or branch protection testing module about the branch circuit.

2. The arc fault root-cause finder apparatus according to claim 1 wherein the sensing electronics (38) of the sensing base module (12) are configured to sense electrical events that indicate an arc fault in the branch circuit under test when a load connected to the branch circuit under test is activated.

3. The arc fault root-cause finder apparatus according to claim 2 wherein the remote user interface module (14) further comprises processing electronics (54) that processes the signals received from sensing base module (12) to provide information on the display device (53) that indicates if an arc has occurred on the branch circuit under test, or that processes the information signals generated by the branch protection testing module (20) and displays the processed information that indicates whether the circuit breaker is functioning properly.

4. The arc fault root-cause finder apparatus according to claim 1 wherein the at least one circuit breaker comprises a plurality of circuit breakers and wherein a plurality of branch circuits (9, 10) are connected to the load panel box (8) wherein each circuit breaker protects a corresponding one of the branch circuits, the sensing base module (12) being electrically connected to each circuit breaker so as to sense the occurrence of arc signals on each branch circuit.

5. The arc fault root-cause finder apparatus according to claim 1 wherein the electronics of the sensing base module (12) further comprises processing electronics (40) to process the signals sensed on the branch circuit under test to derive signal data and data storage electronics (42) to store the signal data.

6. The arc fault root-cause finder apparatus according to claim 1 wherein the remote user interface (14) is configured as a handheld device and comprises a keypad device (56) that is in electronic signal communication with the visual display device (53) and wireless communication electronics (52).

7. The arc fault root-cause finder apparatus according to claim 6 wherein the remote user interface module (14) comprises processing electronics (54) to process signal information received from the sensing base module (12), the processing electronics being in electrical signal communication with the keypad device (56).

8. The arc fault root-cause finder apparatus according to claim 7 wherein the remote user interface module (14) comprises electronics (58) to administer and manage all communications exchanged between the sensing base module (12) and the remote user interface module (14).

9. The arc fault root-cause finder apparatus according to claim 8 wherein the remote user interface module (14) comprises data storage electronics (64) to store the processed signal information.

10. The arc fault root-cause finder apparatus according to claim 9 wherein the remote user interface module (14) further comprises data interfaces (60, 62) to output processed signal information to external data processing equipment.

11. The arc fault root-cause finder apparatus according to claim 1, wherein the apparatus comprises the sensing base module (12) and the apparatus further comprises a branch protection testing module (20) in wireless signal communication with the remote user interface module (14) and in electrical signal communication with the branch circuit (9, 10), the branch protection testing module being in electrical signal communication with the circuit branch and comprising electronics and electrical circuitry (86, 88) to (i) generate electrical signals that represent the characteristics of a true arc and ground fault conditions, (ii) inject the electrical signals into the branch circuit, and (iii) determine the integrity of the wiring in the branch circuit, and (iv) determine if the installed circuit breaker associated with the branch circuit is functioning properly.

12. The arc fault root-cause finder apparatus according to claim 11 wherein the remote user interface module (14) contains electronics for generating commands for the branch protection testing module (20) and enabling the wireless communication electronics to transmit the commands to the branch protection testing module.

13. The arc fault root-cause finder apparatus according to claim 12 wherein the remote user interface module (14) contains data storage electronics to store signal data representing the generated electrical signals injected into the branch circuit and the functioning of the installed circuit breaker.

14. The arc fault root-cause finder apparatus according to claim 12 wherein the remote user interface module (14) comprises an AC power cord that is configured to be plugged into an electrical outlet that is in the branch circuit to be tested, the generated electrical signal being injected into the branch circuit through the AC power cord.

15. A method for finding the source of problem found by a circuit breaker, comprising:
providing at least one circuit breaker that protects a corresponding branch circuit (9, 10) having at least one load device electrically connected to the branch circuit and a sensing base module (12) comprising sensing electronic (38) and wireless communication electronics (36) connected to the circuit breaker;
energizing the at least one load device;
sensing in the sensing electronics (38), the occurrence of arcing events in the branch circuit;
generating electrical signals that represent whether an arcing event has occurred in the branch circuit;
processing the generated electrical signals to derive data that represents either the occurrence or absence of an arcing event in the branch circuit;
communicating wirelessly from the wireless communication electronics (36) to a remote user interface module (14) to effect transmission of the electrical signal; and
displaying the data on a display device.

16. The method according to claim 15 further comprising storing the data in a data storage device.

17. The method according to claim 15 further comprising:
generating electrical signals that represent the characteristics of a true arc and ground fault conditions; and
injecting the electrical signals into the branch circuit.

18. The method according to claim 17 further comprising:
determining if the installed circuit breaker associated with the branch circuit is functioning properly; and
generating information signals that indicate if the installed circuit breaker is or is not functioning properly.

19. The method according to claim 18 further comprising analyzing the electrical response to the injected signal to determine the integrity of the wiring in the branch circuit.

## Patentansprüche

1. Vorrichtung zum Auffinden der Ursache von Lichtbogenfehlern, welche eines von einem Erfassungs-Basismodul (12) und einem Abzweigschutzmodul (20) umfasst; wobei
das Erfassungs-Basismodul (12) an einem Last-Verteilerkasten (8) angebracht ist, der mindestens einen Leistungsschalter aufweist, welcher einen entsprechenden Abzweigstromkreis schützt; das Erfassungs-Basismodul Erfassungselektronik (38) umfasst, welche mit dem mindestens einen Leistungsschalter elektrisch verbunden ist und dafür ausgebildet ist, das Auftreten von Lichtbogenereignissen in dem Abzweigstromkreis (9, 10) zu erfassen, wobei das Erfassungs-Basismodul Drahtloskommunikationselektronik (36) enthält, um (i) die Übertragung elektrischer Signale durchzuführen, welche Informationen über das Auftreten oder Nichtvorhandensein von Lichtbogenereignissen in dem Abzweigstromkreis (9, 10) liefern, und (ii) Steuersignale zu empfangen; wobei
das Abzweigschutz-Prüfmodul (20) zur Verwendung mit einem elektrischen Stromverteilungssystem bestimmt ist, das mindestens einen Leistungsschalter aufweist, welcher einen entsprechenden Abzweigstromkreis schützt, und mit dem Abzweigstromkreis in Kommunikation mittels elektrischer Signale steht und Drahtloskommunikationselektronik (78) und zusätzliche Elektronik und elektrische Schaltungen (86, 88) umfasst, um (i) elektrische Signale zu erzeugen, welche die Merkmale von echten Lichtbogen- und Erdschlussbedingungen repräsentieren, (ii) die elektrischen Signale in den Abzweigstromkreis einzuspeisen und (iii) die Unversehrtheit der Verdrahtung in dem Abzweigstromkreis zu bestimmen, (iv) zu bestimmen, ob der installierte Leistungsschalter, welcher dem Abzweigstromkreis zugeordnet ist, ordnungsgemäß funktioniert, und (v) Informationssignale zu erzeugen, welche angeben, ob der installierte Leistungsschalter ordnungsgemäß funktioniert oder nicht; und wobei
die Vorrichtung ferner ein entferntes Benutzerschnittstellenmodul (Remote User Interface Module) (14) umfasst, das Drahtloskommunikationselektronik (52) umfasst, die dafür ausgebildet ist, eine Kommunikation mit dem Erfassungs-Basismodul (12) oder Abzweigschutz-Prüfmodul (20) herzustellen, um Signale zu empfangen, die von dem Erfassungs-Basismodul (12) oder Abzweigschutz-Prüfmodul (20) gesendet werden, und um Steuersignale an das Erfassungs-Basismodul oder Abzweigschutz-Prüfmodul zu senden, wobei das entfernte Benutzerschnittstellenmodul ferner eine visuelle Anzeigeeinrichtung (53) umfasst, um Informationen über den Abzweigstromkreis anzuzeigen, die von dem Erfassungs-Basismodul oder Abzweigschutz-Prüfmodul empfangen wurden.

2. Vorrichtung zum Auffinden der Ursache von Lichtbogenfehlern nach Anspruch 1, wobei die Erfassungselektronik (38) des Erfassungs-Basismoduls (12) dafür ausgebildet ist, elektrische Ereignisse zu erfassen, welche einen Lichtbogenfehler in dem geprüften Abzweigstromkreis anzeigen, wenn eine an den geprüften Abzweigstromkreis angeschlossene Last eingeschaltet ist.

3. Vorrichtung zum Auffinden der Ursache von Lichtbogenfehlern nach Anspruch 2, wobei das entfernte Benutzerschnittstellenmodul (14) ferner Verarbeitungselektronik (54) umfasst, welche die Signale verarbeitet, die von dem Erfassungs-Basismodul (12) empfangen werden, um auf der Anzeigeeinrichtung (53) Informationen bereitzustellen, die angeben, ob ein Lichtbogen an dem geprüften Abzweigstromkreis aufgetreten ist, oder welche die Informationssignale verarbeitet, die von dem Abzweigschutz-Prüfmodul (20) erzeugt werden, und die verarbeiteten Informationen anzeigt, die angeben, ob der Leistungsschalter ordnungsgemäß funktioniert.

4. Vorrichtung zum Auffinden der Ursache von Lichtbogenfehlern nach Anspruch 1, wobei der mindestens eine Leistungsschalter mehrere Leistungsschalter umfasst und wobei mehrere Abzweigstromkreise (9, 10) an den Last-Verteilerkasten (8) angeschlossen sind, wobei jeder Leistungsschalter einen entsprechenden Abzweigstromkreis schützt, wobei das Erfassungs-Basismodul (12) mit jedem Leistungsschalter elektrisch verbunden ist, um das Auftreten von Lichtbogensignalen an jedem Abzweigstromkreis zu erfassen.

5. Vorrichtung zum Auffinden der Ursache von Lichtbogenfehlern nach Anspruch 1, wobei die Elektronik des Erfassungs-Basismoduls (12) ferner Verarbeitungselektronik (40) umfasst, um die an dem geprüften Abzweigstromkreis erfassten Signale zu verarbeiten, um Signaldaten abzuleiten, und Datenspeicherungselektronik (42), um die Signaldaten zu speichern.

6. Vorrichtung zum Auffinden der Ursache von Lichtbogenfehlern nach Anspruch 1, wobei die entfernte Benutzerschnittstelle (14) als ein Handgerät ausgebildet ist und eine Tastenfeldeinrichtung (56) umfasst, welche mit der visuellen Anzeigeeinrichtung (53) und der Drahtloskommunikationselektronik (52) in Kommunikation mittels elektronischer Signale steht.

7. Vorrichtung zum Auffinden der Ursache von Lichtbogenfehlern nach Anspruch 6, wobei das entfernte Benutzerschnittstellenmodul (14) Verarbeitungselektronik (54) umfasst, um Signalinformationen zu verarbeiten, die von dem Erfassungs-Basismodul (12) empfangen werden, wobei die Verarbeitungselektronik mit der Tastenfeldeinrichtung (56) in Kommunikation mittels elektrischer Signale steht.

8. Vorrichtung zum Auffinden der Ursache von Lichtbogenfehlern nach Anspruch 7, wobei das entfernte Benutzerschnittstellenmodul (14) Elektronik (58) umfasst, um alle Übertragungen zu handhaben und zu verwalten, die zwischen dem Erfassungs-Basismodul (12) und dem entfernten Benutzerschnittstellenmodul (14) durchgeführt werden.

9. Vorrichtung zum Auffinden der Ursache von Lichtbogenfehlern nach Anspruch 8, wobei das entfernte Benutzerschnittstellenmodul (14) Datenspeicherungselektronik (64) umfasst, um die verarbeiteten Signalinformationen zu speichern.

10. Vorrichtung zum Auffinden der Ursache von Lichtbogenfehlern nach Anspruch 9, wobei das entfernte Benutzerschnittstellenmodul (14) ferner Datenschnittstellen (60, 62) umfasst, um verarbeitete Signalinformationen an externe Datenverarbeitungseinrichtungen auszugeben.

11. Vorrichtung zum Auffinden der Ursache von Lichtbogenfehlern nach Anspruch 1, wobei die Vorrichtung das Erfassungs-Basismodul (12) umfasst und die Vorrichtung ferner ein Abzweigschutz-Prüfmodul (20) umfasst, das mit dem entfernten Benutzerschnittstellenmodul (14) in drahtloser Signalkommunikation und mit dem Abzweigstromkreis (9, 10) in Kommunikation mittels elektrischer Signale steht, wobei das Abzweigschutz-Prüfmodul mit dem Schaltungszweig in Kommunikation mittels elektrischer Signale steht und Elektronik und elektrische Schaltungen (86, 88) umfasst, um (i) elektrische Signale zu erzeugen, welche die Merkmale von echten Lichtbogen- und Erdschlussbedingungen repräsentieren, (ii) die elektrischen Signale in den Abzweigstromkreis einzuspeisen und (iii) die Unversehrtheit der Verdrahtung in dem Abzweigstromkreis zu bestimmen und (iv) zu bestimmen, ob der installierte Leistungsschalter, welcher dem Abzweigstromkreis zugeordnet ist, ordnungsgemäß funktioniert.

12. Vorrichtung zum Auffinden der Ursache von Lichtbogenfehlern nach Anspruch 11, wobei das entfernte Benutzerschnittstellenmodul (14) Elektronik zum Erzeugen von Befehlen für das Abzweigschutz-Prüfmodul (20) und zum Befähigen der Drahtloskommunikationselektronik, die Befehle zu dem Abzweigschutz-Prüfmodul zu übertragen, enthält.

13. Vorrichtung zum Auffinden der Ursache von Lichtbogenfehlern nach Anspruch 12, wobei das entfernte Benutzerschnittstellenmodul (14) Datenspeicherungselektronik enthält, um Signaldaten zu speichern, welche die erzeugten elektrischen Signale, die in den Abzweigstromkreis eingespeist werden, und das Funktionieren des installierten Leistungsschalters repräsentieren.

14. Vorrichtung zum Auffinden der Ursache von Lichtbogenfehlern nach Anspruch 12, wobei das entfernte Benutzerschnittstellenmodul (14) ein Wechselstromkabel umfasst, welches dafür ausgebildet ist, an eine elektrische Steckdose angeschlossen zu werden, welche sich in dem zu prüfenden Abzweigstromkreis befindet, wobei das erzeugte elektrische Signal über das Wechselstromkabel in den Abzweigstromkreis eingespeist wird.

15. Verfahren zum Auffinden der Ursache eines durch einen Leistungsschalter festgestellten Problems, welches umfasst:
Bereitstellen mindestens eines Leistungsschalters, welcher einen entsprechenden Abzweigstromkreis (9, 10) schützt, der mindestens eine mit dem Abzweigstromkreis elektrisch verbundene Lasteinrichtung aufweist, und eines Erfassungs-Basismoduls (12), das Erfassungselektronik (38) und Drahtloskommunikationselektronik (36) umfasst und mit dem Leistungsschalter verbunden ist;
Einschalten der mindestens einen Lasteinrichtung;
Erfassen, in der Erfassungselektronik (38), des Auftretens von Lichtbogenereignissen in dem Abzweigstromkreis;
Erzeugen elektrischer Signale, welche repräsentieren, ob ein Lichtbogenereignis in dem Abzweigstromkreis aufgetreten ist;
Verarbeiten der erzeugten elektrischen Signale, um Daten abzuleiten, welche entweder das Auftreten oder das Nichtvorhandensein eines Lichtbogenereignisses in dem Abzweigstromkreis repräsentieren;
drahtloses Kommunizieren von der Drahtloskommunikationselektronik (36) zu einem entfernten Benutzerschnittstellenmodul (14), um eine Übertragung des elektrischen Signals durchzuführen; und
Anzeigen der Daten auf einer Anzeigeeinrichtung.

16. Verfahren nach Anspruch 15, welches ferner das Speichern der Daten in einer Datenspeicherungseinrichtung umfasst.

17. Verfahren nach Anspruch 15, welches ferner umfasst:
Erzeugen elektrischer Signale, welche die Merkmale von echten Lichtbogen- und Erdschlussbedingungen repräsentieren; und
Einspeisen der elektrischen Signale in den Abzweigstromkreis.

18. Verfahren nach Anspruch 17, welches ferner umfasst:
Bestimmen, ob der installierte Leistungsschalter, welcher dem Abzweigstromkreis zugeordnet ist, ordnungsgemäß funktioniert; und
Erzeugen von Informationssignalen, welche angeben, ob der installierte Leistungsschalter ordnungsgemäß funktioniert oder nicht.

19. Verfahren nach Anspruch 18, welches ferner das Analysieren der elektrischen Reaktion auf das eingespeiste Signal umfasst, um die Unversehrtheit der Verdrahtung in dem Abzweigstromkreis zu bestimmen.

## Revendications

1. Dispositif de détection de la cause première d'un défaut d'arc, comprenant soit un module détecteur de base (12), soit un module de protection de branche (20), étant entendu que le module détecteur de base (12) est monté sur un coffret de tableau de charges (8) comportant au moins un disjoncteur qui protège une branche de circuit correspondante, le module détecteur de base comprenant une électronique de détection (38) qui est reliée électriquement au au moins un disjoncteur et configurée pour détecter l'apparition de phénomènes d'arc dans la branche de circuit (9, 10), le module détecteur de base comprenant une électronique de communication sans fil (36) (i) pour effectuer la transmission de signaux électriques qui fournissent des informations sur l'apparition ou l'absence de phénomènes d'arc dans la branche de circuit (9, 10) et (ii) pour recevoir des signaux de commande, étant entendu que le module d'essai de protection de branche (20) est destiné à être utilisé avec un système de distribution de courant électrique comportant au moins un disjoncteur qui protège une branche de circuit correspondante et est en communication par signaux électriques avec la branche de circuit et comprenant une électronique de communication sans fil (78) et des circuits électroniques et électriques additionnels (86, 88) (i) pour produire des signaux électriques qui représentent les caractéristiques d'une situation réelle de défaut d'arc et à la terre, (ii) pour injecter les signaux électriques dans la branche de circuit, et (iii) pour déterminer l'intégrité du câblage de la branche de circuit, (iv) pour déterminer si le disjoncteur installé associé à la branche de circuit fonctionne correctement et (v) pour produire des signaux d'information qui indiquent si le disjoncteur installé fonctionne ou ne fonctionne pas correctement, et étant entendu que le dispositif comprend par ailleurs un module d'interface pour utilisateur distant (14) comprenant une électronique de communication sans fil (52) configurée pour établir la communication avec le module détecteur de base (12) ou le module d'essai de protection de branche (20) de sorte à recevoir les signaux transmis par le module détecteur de base (12) ou le module d'essai de protection de branche (20) et à transmettre des signaux de commande au module détecteur de base ou au module d'essai de protection de branche, le module d'interface pour utilisateur distant comprenant par ailleurs un dispositif d'affichage visuel (53) pour afficher les informations reçues du module détecteur de base ou du module d'essai de protection de branche à propos de la branche de circuit.

2. Dispositif de détection de la cause première d'un défaut d'arc selon la revendication 1 dans lequel l'électronique de détection (38) du module détecteur de base (12) est configurée pour détecter des phénomènes électriques qui indiquent un défaut d'arc dans la branche de circuit testée lorsqu'une charge reliée à la branche de circuit testée est activée.

3. Dispositif de détection de la cause première d'un défaut d'arc selon la revendication 2 dans lequel le module d'interface pour utilisateur distant (14) comprend par ailleurs une électronique de traitement (54) qui traite les signaux reçus du module détecteur de base (12) pour fournir des informations sur le dispositif d'affichage (53) qui indiquent si un arc est apparu sur la branche de circuit testée, ou qui traite les signaux d'information produits par le module d'essai de protection de branche (20) et affiche les informations traitées qui indiquent si le disjoncteur fonctionne correctement.

4. Dispositif de détection de la cause première d'un défaut d'arc selon la revendication 1 dans lequel le au moins un disjoncteur consiste en une pluralité de disjoncteurs et dans lequel une pluralité de branches de circuit (9, 10) sont reliées au coffret de tableau de charges (8) étant entendu que chaque disjoncteur protège une branche de circuit correspondante, le module détecteur de base (12) étant relié électriquement à chaque disjoncteur de sorte à détecter l'apparition de signaux d'arc sur chaque branche de circuit.

5. Dispositif de détection de la cause première d'un défaut d'arc selon la revendication 1 dans lequel l'électronique du module détecteur de base (12) comprend par ailleurs une électronique de traitement (40) pour traiter les signaux détectés sur la branche de circuit testée en vue de dériver des données des signaux et une électronique de stockage de données (42) pour stocker les données de signaux.

6. Dispositif de détection de la cause première d'un défaut d'arc selon la revendication 1 dans lequel l'interface pour utilisateur distant (14) est configurée sous la forme d'un dispositif portatif et comprend un dispositif à clavier (56) qui est en communication par signaux électroniques avec le dispositif d'affichage visuel (53) et l'électronique de communication sans fil (52).

7. Dispositif de détection de la cause première d'un défaut d'arc selon la revendication 6 dans lequel le module d'interface pour utilisateur distant (14) comprend une électronique de traitement (54) pour traiter les informations de signaux reçus du module détecteur de base (12), l'électronique de traitement étant en communication par signaux électriques avec le dispositif à clavier (56).

8. Dispositif de détection de la cause première d'un défaut d'arc selon la revendication 7 dans lequel le module d'interface pour utilisateur distant (14) comprend une électronique (58) pour administrer et gérer toutes les communications échangées entre le module détecteur de base (12) et le module d'interface pour utilisateur distant (14).

9. Dispositif de détection de la cause première d'un défaut d'arc selon la revendication 8 dans lequel le module d'interface pour utilisateur distant (14) comprend une électronique de stockage de données (64) pour stocker les informations de signaux traitées.

10. Dispositif de détection de la cause première d'un défaut d'arc selon la revendication 9 dans lequel le module d'interface pour utilisateur distant (14) comprend par ailleurs des interfaces de données (60, 62) pour envoyer des informations de signaux traitées à des équipements externes de traitement de données.

11. Dispositif de détection de la cause première d'un défaut d'arc selon la revendication 1, étant entendu que le dispositif comprend le module détecteur de base (12) et que le dispositif comprend par ailleurs un module d'essai de protection de branche (20) en communication par signaux sans fil avec le module d'interface pour utilisateur distant (14) et en communication par signaux électriques avec la branche de circuit (9, 10), le module d'essai de protection de branche étant en communication par signaux électriques avec la branche de circuit et comprenant des circuits électroniques et électriques (86, 88) (i) pour produire des signaux électriques qui représentent les caractéristiques d'une situation réelle de défaut d'arc et à la terre, (ii) pour injecter les signaux électriques dans la branche de circuit et (iii) pour déterminer l'intégrité du câblage de la branche de circuit, et (iv) pour déterminer si le disjoncteur installé associé à la branche de circuit fonctionne correctement.

12. Dispositif de détection de la cause première d'un défaut d'arc selon la revendication 1 dans lequel le module d'interface pour utilisateur distant (14) contient une électronique pour produire des commandes pour le module d'essai de protection de branche (20) et permettre à l'électronique de communication sans fil de transmettre les commandes au module d'essai de protection de branche.

13. Dispositif de détection de la cause première d'un défaut d'arc selon la revendication 12 dans lequel le module d'interface pour utilisateur distant (14) contient une électronique de stockage de données pour stocker les données de signaux représentant les signaux électriques produits injectés dans la branche de circuit et le fonctionnement du disjoncteur installé.

14. Dispositif de détection de la cause première d'un défaut d'arc selon la revendication 12 dans lequel le module d'interface pour utilisateur distant (14) comprend un cordon d'alimentation en courant alternatif qui est configuré pour être enfiché dans une prise de courant électrique qui est dans la branche de circuit à tester, le signal électrique produit étant injecté dans la branche de circuit par l'intermédiaire du cordon d'alimentation en courant alternatif.

15. Procédé de détection de la source d'un problème détecté par un disjoncteur, consistant :
à procurer au moins un disjoncteur qui protège une branche de circuit correspondante (9, 10) comportant au moins un dispositif formant charge relié électriquement à la branche de circuit et un module détecteur de base (12) comprenant une électronique de détection (38) et une électronique de communication sans fil (36) reliées au disjoncteur ;
à mettre sous tension le au moins un dispositif formant charge ;
à détecter dans l'électronique de détection (38) l'apparition de phénomènes d'arc dans la branche de circuit ;
à produire des signaux électriques qui indiquent si un phénomène d'arc s'est produit dans la branche de circuit ;
à traiter les signaux électriques produits pour en dériver des données qui indiquent soit l'apparition, soit l'absence d'un phénomène d'arc dans la branche de circuit ;
à communiquer sans fil de l'électronique de communication sans fil (36) à un module d'interface pour utilisateur distant (14) pour effectuer la transmission du signal électrique, et
à afficher les données sur un dispositif d'affichage.

16. Procédé selon la revendication 15 consistant par ailleurs à stocker les données dans un dispositif de stockage de données.

17. Procédé selon la revendication 15 consistant par ailleurs :
à produire des signaux électriques qui représentent les caractéristiques d'une situation réelle de défaut d'arc et à la terre, et
à injecter les signaux électriques dans la branche de circuit.

18. Procédé selon la revendication 17 consistant par ailleurs :
à déterminer si le disjoncteur installé associé à la branche de circuit fonctionne correctement, et
à produire des signaux d'information qui indiquent si le disjoncteur installé fonctionne ou ne fonctionne pas correctement.

19. Procédé selon la revendication 18 consistant par ailleurs à analyser la réaction électrique au signal injecté pour déterminer l'intégrité du câblage de la branche de circuit.
